# EUROPEAN PATENT APPLICATION

(11) **EP 4 475 271 A1**
(43) Date of publication of application: **11.12.2024**
(21) Application number: 22960155.4
(22) Date of filing: 29.09.2022
(51) Int. Cl.: H01M 10/48, H01M 50/15

(54) **END COVER ASSEMBLY OF BATTERY CELL, BATTERY CELL, BATTERY, AND ELECTRICAL APPARATUS**

(71) Applicant: Contemporary Amperex Technology (Hong Kong) Limited, Central, Central And Western District (HK)
(72) Inventor: CHEN, Long, Ningde, Fujian 352100 (CN); LIN, Denghua, Ningde, Fujian 352100 (CN); CHEN, Xinxiang, Ningde, Fujian 352100 (CN); HUANG, Shoujun, Ningde, Fujian 352100 (CN); ZHENG, Yulian, Ningde, Fujian 352100 (CN); WANG, Peng, Ningde, Fujian 352100 (CN); JIN, Haizu, Ningde, Fujian 352100 (CN)
(74) Representative: Kraus & Lederer PartGmbB
(86) International application number: PCT/CN2022/122901
(87) International publication number: WO 2024/065520

(57) **Abstract**

Embodiments of the present application provide an end cover assembly of a battery cell, a battery cell, a battery and an electricity-consuming apparatus. The end cover assembly includes an end cover, a detecting assembly and an insulating member. The detecting assembly is arranged on the end cover and configured to detect a state information of the battery cell. The insulating member is attached to a surface of the end cover away from an electrode assembly of the battery cell, and provided with an avoiding structure which is configured to avoid at least a portion of the detecting assembly. By providing the avoiding structure on the insulating member, the risk of interference between the detecting assembly and insulating member can be reduced, the connection strength between the insulating member and the end cover can be improved, and the detecting accuracy of the detecting assembly can be improved.

## Description

### TECHNICAL FIELD

The present application relates to the technical field of battery, and in particular to an end cover assembly of a battery cell, a battery cell, a battery and an electricity-consuming apparatus.

### BACKGROUND

A battery cell is widely used in an electricity device, such as a mobile phone, a laptop, a battery vehicle, an electric car, an electric plane, an electric ship, an electric toy car, an electric toy ship, an electric toy plane and an electric tool.

In the battery technology, how to improve the safety of the battery cell is a research direction.

### SUMMARY

The present application provides an end cover assembly of a battery cell, a battery cell, a battery and an electricity-consuming apparatus, which can improve the safety.

In a first aspect, embodiments of the present application provide an end cover assembly of a battery cell, including an end cover, a detecting assembly and an insulating member. The detecting assembly is arranged on the end cover and configured to detect a state information of the battery cell. The insulating member is attached to a surface of the end cover away from an electrode assembly of the battery cell and provided with an avoiding structure which is configured to avoid at least a portion of the detecting assembly.

The detecting assembly can detect the state information of the battery cell in real time, so that the battery cell can be regulated based on the state information of the battery cell, the cycling performance of the battery cell can be improved, the risk of the safety can be reduced, and the cycling life of the battery cell can be prolonged. By providing the avoiding structure on the insulating member, the risk of interference between the detecting assembly and insulating member can be reduced, the connection strength between the insulating member and the end cover can be improved, and the detecting accuracy of the detecting assembly can be improved.

In some embodiments, the state information includes at least one of a temperature of the battery cell, a voltage of the battery cell, a deformation of the end cover and an internal pressure of the battery cell.

In some embodiments, the avoiding structure exposes at least a portion of the detecting assembly, so as to facilitate the connection between the detecting assembly and a component on an outside of the battery cell.

In some embodiments, the end cover is provided with a concave part, which is recessed from a surface of the end cover away from the electrode assembly. At least a portion of the detecting assembly is accommodated in the concave part.

By arranging the concave part on the end cover, the size of a portion of the detecting assembly protruding from the surface of the end cover away from the electrode assembly can be reduced, the space occupied by the end cover assembly can be reduced, the energy density of the battery cell can be improved, and the risk of interference between the detecting assembly and the insulating member can be reduced.

In some embodiments, a convex part is arranged on a side of the end cover facing the electrode assembly and corresponds to the concave part in position.

By arranging the convex part, the strength of the portion of the end cover corresponding to the concave part can be improved, and the risk of rupture of the end cover can be reduced. On the premise of meeting the strength requirement, by arranging the convex part, a depth of the concave part can increase, so that more accommodating space can be provided for the detecting assembly, an overall size of the battery cell can be reduced, and the energy density can be improved.

In some embodiments, the end cover assembly further includes a first electrode terminal and a second electrode terminal with opposite polarities, the first electrode terminal and the second electrode terminal are mounted on the end cover, and the detecting assembly is electrically connected to the first electrode terminal and the second electrode terminal.

The detecting assembly can detect an electric potential of the first electrode terminal and an electric potential of the second electrode terminal, thereby obtaining a voltage of the battery cell and detecting a working state of the battery cell.

In some embodiments, the detecting assembly includes a chip, a first wire harness and a second wire harness, and the chip is electrically connected to the first electrode terminal through the first wire harness and electrically connected to the second electrode terminal through the second wire harness. The avoiding structure exposes at least a portion of the chip.

The first wire harness can transmit an electric potential signal of the first electrode terminal to the chip, and the second wire harness can transmit an electric potential signal of the second electrode terminal to the chip. The chip can calculate the voltage of the battery cell based on the electric potential signal of the first electrode terminal and the electric potential signal of the second electrode terminal. The avoiding structure exposes at least a portion of the chip, so as to facilitate the chip providing the voltage signal feedback to a control component on the outside of the battery cell.

In some embodiments, the end cover is provided with a concave part, which is recessed from a surface of the end cover away from the electrode assembly. At least a portion of the first wire harness, at least a portion of the second wire harness and at least a portion of the chip are accommodated in the concave part.

The concave part can provide the accommodating space for the first wire harness, the second wire harness and the chip, so that the space occupied by the end cover assembly can be reduced, the energy density of the battery cell can be improved, and the risk of interference between the detecting assembly and the insulating member can be reduced.

In some embodiments, the avoiding structure exposes a portion of the first wire harness corresponding to the concave part and a portion of the second wire harness corresponding to the concave part.

According to the embodiments of the present application, the standard for the depth of the concave part can be reduced; even if the first wire harness and second wire harness protrude to the outside of the concave part, the avoiding structure can still avoid the first wire harness and the second wire harness, so that the risk of interference between the insulating member and the first wire harness and the risk of interference between the insulating member and the second wire harness can be reduced.

In some embodiments, the insulating member covers at least a portion of the first wire harness. The insulating member can protect the first wire harness at the outside, so that the risk of the damage of the first wire harness by an external component can be reduced, the leakage of electricity can be reduced, and the insulating performance can be improved.

In some embodiments, the insulating member abuts against the first wire harness in a thickness direction of the end cover. The insulating member can limit the first wire harness in the thickness direction, so that the movement of the first wire harness can be reduced, the force on the first wire harness can be reduced, and the risk of breaking at a connecting place between the first wire harness and the chip can be reduced when the battery cell is subjected to the external impact.

In some embodiments, the insulating member includes a base layer and a bonding layer, the bonding layer is located between the end cover and the base layer and is bonded to the end cover and the base layer. By arranging the bonding layer, the assembling process of the insulating member and the end cover can be simplified.

In some embodiments, the avoiding structure includes a first hole that penetrates through the base layer and a second hole that penetrates through the bonding layer, and the second hole includes a first region corresponding to the first hole and a second region covered by the base layer. A portion of the chip is accommodated in the first region and the first hole, and a portion of the first wire harness is accommodated in the second region.

By removing a portion of the bonding layer, the second region which can accommodate the first wire harness is formed, so that the standard for the depth of the concave part can be reduced. The base layer may cover the first wire harness, so that the risk of the damage of the first wire harness by the external component can be reduced, the leakage of electricity can be reduced, and the insulating performance can be improved.

In some embodiments, the bonding layer does not overlap with the concave part in a thickness direction of the end cover. According to the embodiments of the present application, the bonding layer overflowing into the concave part can be reduced, and the risk of the interference between the bonding layer and the detecting assembly at the inside of the concave part can be reduced.

In some embodiments, the first wire harness includes a first wire harness segment, a second wire harness segment and a connector, the first wire harness segment is connected to the chip, the second wire harness segment is connected to the first electrode terminal, and the connector is configured to connect the first wire harness segment with the second wire harness segment. By arranging the connector, the assembling process of detecting assembly can be simplified, so that it is convenient to maintain and replace the detecting assembly.

In some embodiments, the chip includes a voltage sensor, a temperature sensor and a displacement sensor, the voltage sensor is electrically connected to the first wire harness and second wire harness, and both of the temperature sensor and the displacement sensor are connected to the end cover. The chip can detect the temperature of the battery cell and the deformation amount and the voltage of the end cover.

In some embodiments, the insulating member further includes a first through hole, and the first electrode terminal passes through the insulating member through the first through hole. The avoiding structure is communicated with the first through hole. The first wire harness can enter into the first through hole through the avoiding structure, so as to facilitate connecting with the first electrode terminal mounted in the first through hole and reduce the risk of interference between the first wire harness and the insulating member.

In a second aspect, embodiments of the present application provide a battery cell including a casing, an electrode assembly and the end cover assembly. The casing is provided with an opening. The electrode assembly is accommodated in the casing. The end cover of the end cover assembly is configured to cover the opening.

In a third aspect, embodiments of the present application provide a battery including the battery cell according to any one of the embodiments in the second aspect.

In a fourth aspect, embodiments of the present application provide an electricity-consuming apparatus including the battery according to any one of the embodiments in the third aspect, which is configured to supply electric power.

### BRIEF DESCRIPTION OF THE DRAWINGS

In order to more clearly illustrate the technical solutions of the embodiments of the present application, the drawings to be used in the description of the embodiments of the present application will be described briefly below. Obviously, the drawings in the following description are merely some embodiments of the present application. For those skilled in the art, other drawings can also be obtained according to these drawings without the inventive labor.
Fig. 1 shows a structural schematic view of a vehicle according to some embodiments of the present application;
Fig. 2 shows an exploded schematic view of a battery according to some embodiments of the present application;
Fig. 3 shows a perspective structural schematic view of a battery cell according to some embodiments of the present application;
Fig. 4 shows an exploded schematic view of the battery cell shown in Fig. 3;
Fig. 5 shows a structural schematic view of an end cover assembly according to some embodiments of the present application;
Fig. 6 shows an exploded schematic view of the end cover assembly shown in Fig. 5;
Fig. 7 shows an enlarged schematic view at circle frame A of Fig. 6;
Fig. 8 shows another exploded schematic view of the end cover assembly shown in Fig. 5;
Fig. 9 shows a cross-sectional schematic view of an end cover assembly according to some embodiments of the present application;
Fig. 10 shows an exploded schematic view of an end cover assembly according to some other embodiments of the present application;
Fig. 11 shows a cross-sectional schematic view of an end cover assembly according to some other embodiments of the present application;
Fig. 12 shows a structural schematic view of an end cover assembly according to some other embodiments of the present application;
Fig. 13 shows an exploded schematic view of the end cover assembly shown in Fig. 12;
Fig. 14 shows an exploded schematic view of an end cover assembly according to some other embodiments of the present application;
Fig. 15 shows a structural schematic view of the detecting assembly shown in Fig. 14;
Fig. 16 shows a structural schematic view of an end cover of an end cover assembly according to some embodiments of the present application; and
Fig. 17 shows a structural schematic view of the end cover shown in Fig. 16 at another angle.

In the drawings, the drawings are not drawn to actual scale.

### DETAILED DESCRIPTION

In order to make the objects, technical solutions and advantages of the embodiments of the present application more clear, the technical solutions of the embodiments of the present application will be clearly and completely described below in conjunction with the drawings of the embodiments of the present application. It is apparent that the described embodiments are a portion of the embodiments of the present application, and not all of them. Based on the embodiments of the present application, all other embodiments obtained by those skilled in the art without the creative labor fall within the scope of the present application.

Unless otherwise defined, technical terms or scientific terms used in the present disclosure should be interpreted according to common meanings thereof as commonly understood by those of ordinary skills in the art. The terms used in the description in the present application are only for the purpose of describing specific embodiments and are not intended to limit the present application. The terms "including" and "having" in the description and the claims of the present application and the above description of the drawings, and any variations thereof are intended to cover non-exclusive inclusions. The terms "first", "second", etc. in the description and the claims of the present application or the above-mentioned drawings are used to distinguish different objects, rather than to describe a specific order or a primary-secondary relationship.

The "embodiments" referred in the present application means that specific features, structures or characteristics described in conjunction with the embodiments may be included in at least one embodiment of the present application. This word appeared in various places in the description does not necessarily refer to the same embodiment, nor is it an independent or alternative embodiment mutually exclusive with other embodiments.

In the description of the present application, it should be noted that, unless otherwise clearly specified and limited, the terms "mount", "connecting" and "connection" and "attach" should be understood in a broad sense, for example, it can be a fixed connection, a detachable connection, or an integral connection, it can be connected directly, it can be connected indirectly through an intermedium, or it can be a communication between two elements at insides thereof. For those of ordinary skill in the art, the specific meaning of the above-mentioned terms in the present application can be understood according to specific situations.

The term "and/or" in the present application is merely an association relationship describing associated objects, which means that there can be three types of relationships. For example, "A and/or B" can mean three cases that there is only A, there are A and B at the same time, and there is only B. In addition, the punctuation mark "/" in the present application generally indicates that the related objects of the preceding content and following content are in an "or" relationship.

In the embodiments of the present application, the same reference numerals denote the same components, and for the sake of brevity, in different embodiments, detailed descriptions of the same components are omitted. It should be understood that the thickness, length, width and other sizes of the various components in the embodiments of the present application shown in the drawings, as well as the overall thickness, length and width, etc., of the integrated device are only exemplary descriptions, and should not constitute any limitation to the present application.

The "plurality" in the present application refers to two or more (including two).

In the present application, a battery cell may include a lithium-ion secondary battery cell, a lithium-ion primary battery cell, a lithium-sulfur battery cell, a sodium lithium ion battery cell, a sodium ion battery cell, a magnesium ion battery cell and the like, which is not limited in the embodiments of the present application. The battery cell can be in a shape of a cylinder, a flatten body, a cuboid or other shapes, which is not limited in the embodiments of the present application.

In the present application, a battery cell may include a lithium-ion secondary battery cell, a lithium-ion primary battery cell, a lithium-sulfur battery cell, a sodium lithium ion battery cell, a sodium ion battery cell, a magnesium ion battery cell and the like, which is not limited in the embodiments of the present application. The battery cell can be in a shape of a cylinder, a flatten body, a cuboid or other shapes, which is not limited in the embodiments of the present application.

The battery mentioned in the embodiments of the present application refers to a single physical module that includes one or more battery cells to provide higher voltage and capacity. For example, the battery mentioned in the present application may include a battery module, a battery pack or the like. The battery generally includes a housing for packaging one or more battery cells. The housing can prevent liquid or other foreign objects from affecting the electrical charge or the electrical discharge of the battery cell.

The battery cell includes an electrode assembly and an electrolyte, and the electrode assembly includes a positive electrode plate, a negative electrode plate and a separator. The battery cell mainly relies on the movement of metal ions between the positive electrode plate and the negative electrode plate to work. The positive electrode plate includes a positive electrode applying region and a positive electrode tab connected to the positive electrode applying region. The positive electrode active material layer is applied on the positive electrode applying region and is not applied on the positive electrode tab. Taking a lithium ion battery as an example, the material of the positive electrode current collector may be aluminum, and the positive electrode active material layer includes a positive electrode active material, which may be lithium cobaltate, lithium iron phosphate, ternary lithium, lithium manganite or the like. The negative electrode plate includes a negative electrode current collector and a negative electrode active material layer applied on the surface of the negative electrode current collector. The negative electrode current collector includes a negative electrode applying region and a negative electrode tab connected to the negative electrode applying region. The negative electrode active material layer is applied on the negative electrode applying region and is not applied on the negative electrode tab. The material of the negative electrode current collector may be copper, and the negative electrode active material layer includes a negative electrode active material, which may be carbon, silicon or the like. The material of the separator may be PP (polypropylene), PE (polyethylene) or the like.

The battery cell further includes a casing and an end cover, the casing is provided with an opening, and the end cover covers the opening of the casing and encloses with the casing to form an accommodating cavity for accommodating the electrode assembly. The casing and end cover can protect the electrode assembly at the outside, so as to prevent the charging or discharging of the electrode assembly from being affected by external foreign objects.

During a cycling process of the battery cell, an abnormal condition may occur. For example, after experiencing a plurality of charging and discharging cycles, the battery cell may occur the side reaction and continuously produce gas at the inside of the battery cell. The gas will increase the pressure at the inside of the battery cell, which may lead to the risk of the deformation and rupture of an outer casing. In addition, for example, when a short circuit occurs at the inside of the battery cell, the battery cell generates heat and heats up, so that it may lead to the risk of thermal runaway of the battery cell.

During using the battery, if the abnormal situation of the battery cell cannot be detected and dealt with in time, it will lead to the deterioration of the battery cell and cause the safety accident.

The inventors intend to mount a detecting assembly on the end cover, which can detect a state information of the battery cell in real time, thereby regulating the battery cell based on the state information, improving the cycling performance of the battery cell, reducing the risk of safety, and prolonging the cycling life of the battery cell.

In order to improve the safety of the battery cell, the inventors attach an insulating member to a surface of the end cover; the insulating member can separate the end cover from other components at the outside of the battery cell to reduce the risk of short circuit.

However, the inventors found that mounting the detecting assembly onto the end cover would lead to the risk of interference between the detecting assembly and the insulating member. If the detecting assembly is mounted firstly and then the insulating member is mounted, the detecting assembly will be prone to interfere with the insulating member, so that the insulating member may curl up and be difficult to tightly fit with the end cover. If the insulating member is mounted firstly and then the detecting assembly is mounted, the insulating member will separate the detecting assembly from the end cover, so that the detecting assembly is difficult to accurately detect the state of the end cover, thereby decreasing the detecting accuracy.

In view of this, the embodiments of present application provide a technical solution that the insulating member is provided with an avoiding structure, so that the risk of interference between the detecting assembly and the insulating member can be reduced, the connection strength between the insulating member and the end cover can be improved, and the detecting accuracy of the detecting assembly can be improved.

The technical solution described in the embodiments of the present application is applicable to the battery and an electricity-consuming apparatus using the battery.

The electricity-consuming apparatus may be a vehicle, a mobile phone, a portable device, a notebook computer, a ship, a spacecraft, an electric toy, an electric tool or the like. The vehicle may be a fuel car, a gas car or a new energy car, and the new energy car can be a pure electric car, a hybrid car, a range-extended car or the like; the spacecraft may include an airplane, a rocket, a space shuttle, a space ship or the like; the electric toy may include a fixed-type or mobile-type electric toy, such as a game player, an electric car toy, an electric ship toy, an electric airplane toy or the like; the power tool may include a metal cutting power tool, a grinding power tool, an assembly power tool and a railway power tools, such as an electric drill, an electric grinder, an electric wrench, an electric screwdriver, an electric hammer, an impact drill, a concrete vibrator, an electric planers or the like. Embodiments of the present application do not impose specific limitation to the above-mentioned electricity-consuming apparatus.

For the convenience of explanation, the following embodiments take a vehicle being as the electricity-consuming apparatus as an example to illustrate.

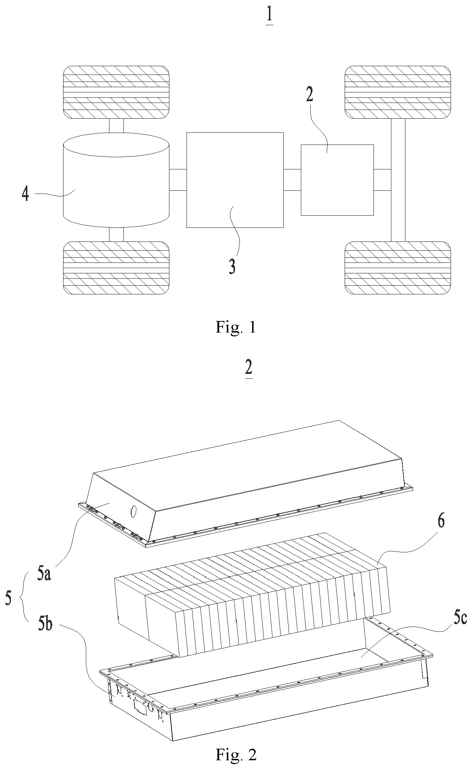

Fig. 1 shows a structural schematic view of a vehicle according to some embodiments of the present application.

As shown in Fig. 1, a battery 2 may be arranged at the inside of the vehicle 1, and the battery 2 may be arranged in the bottom, the front or the back of the vehicle 1. The battery 2 can be used to supply power to the vehicle 1, for example, the battery 2 can be used as an operating power source of the vehicle 1.

The vehicle 1 may further include a controller 3 and a motor 4. The controller 3 can be used to control the battery 2 to supply power to the motor 4, for example, for satisfying the work electricity needs of the vehicle 1 during starting, navigating and driving.

In some embodiments of the present application, the battery 2 can not only serve as an operating power source for the vehicle 1, but also as a driving power source for the vehicle 1, so as to replace or partially replace the fuel or the natural gas and provide the driving power for the vehicle 1.

Fig. 2 shows an exploded structural schematic view of a battery according to some embodiments of the present application.

As shown in Fig. 2, the battery 2 includes a housing 5 and a battery cell 6 (not shown) which is accommodated in the housing 5.

The housing 5 is used to accommodate the battery cell 6, and the housing 5 can be of various structural forms. In some embodiments, the housing 5 may include a first housing portion 5a and a second housing portion 5b. The first housing portion 5a and the second housing portion 5b cover each other. The first housing portion 5a and the second housing portion 5b jointly define an accommodating space 5c for accommodating the battery cell 6. The second housing portion 5b may be a hollow structure having an opening at an end, and the first housing portion 5a may be a plate-like structure. The first housing portion 5a is covered with the side of the second housing portion 5b with the opening to form the housing 5 having the accommodating space 5c. Or each of the first housing portion 5a and the second housing portion 5b may be a hollow structure having an opening on a side. The side of the first housing portion 5a with the opening is covered with the side of the second housing portion 5b with the opening to form the housing 5 having the accommodation space 5c. Of course, the first housing portion 5a and the second housing portion 5b may be in various shapes, such as a cylinder and a rectangular parallelepiped.

In order to improve the sealing performance after the first housing portion 5a is connected with the second housing portion 5b, a sealing member, such as a sealant and a sealing ring, may be arranged between the first housing portion 5a and the second housing portion 5b.

It can be assumed that the first housing portion 5a is covered with the second housing portion 5b, the first housing portion 5a can be called an upper housing cover, and the second housing portion 5b can be called a lower housing portion.

In the battery 2, there may be one or more battery cells 6. If there are a plurality of battery cells 6, the plurality of battery cells 6 can be connected in series, in parallel or in hybrid. The hybrid connection means that the plurality of battery cells 6 are connected in series and parallel in combination. The plurality of battery cells 6 can be directly connected in series, parallel or hybrid together, and then a whole composed of the plurality of battery cells 6 can be accommodated in the housing 5. Or the plurality of battery cells 6 can be connected in series, in parallel or hybrid to form the battery module. A plurality of battery modules are connected in series, in parallel or in hybrid to form a whole and are accommodated in the housing 5.

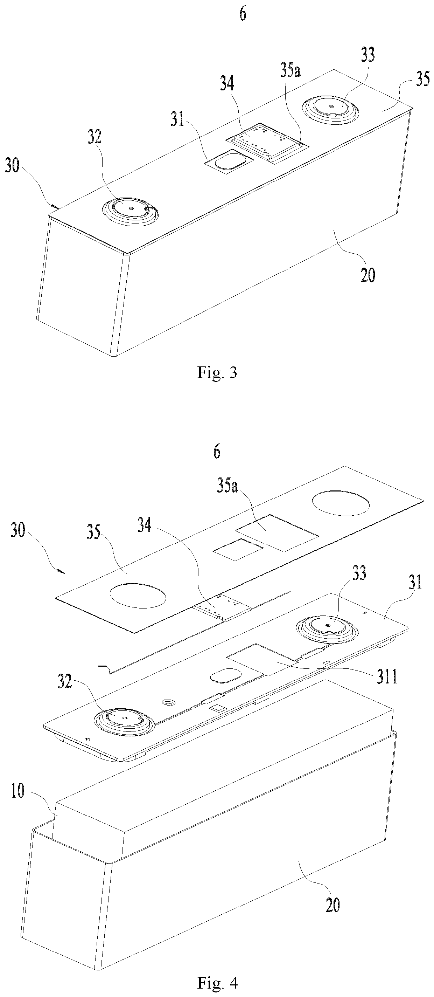

Fig. 3 shows a perspective structural schematic view of a battery cell according to some embodiments of the present application; Fig. 4 shows an exploded structural schematic view of the battery cell shown in Fig. 3.

As shown in Fig. 3 and Fig. 4, the embodiments of the present application provide a battery cell 6 including an electrode assembly 10, a casing 20, and an end cover assembly 30. The casing 20 is provided with an opening. The electrode assembly 10 is accommodated in the casing 20. The end cover assembly 30 is used to cover the opening.

The electrode assembly 10 includes a positive electrode plate and a negative electrode plate. Exemplarily, electrode assembly 10 generates the electrical energy through the oxidation and reduction reaction during the insertion/extraction of ions in the positive electrode plate and the negative electrode plate. Optionally, the electrode assembly 10 further includes a separator, which is used to insulate and separate the positive electrode plate and the negative electrode plate.

The electrode assembly 10 may be a wound electrode assembly, a stacked electrode assembly or another type of electrode assembly.

There may be one or more electrode assemblies 10. When a plurality of electrode assemblies 10 are provided, the plurality of electrode assemblies 10 can be arranged and stacked in layers.

The casing 20 is a hollow structure. The shape of casing 20 may be determined based on the specific shape of electrode assembly 10. For example, if the electrode assembly 10 is a cuboid structure, a cuboid casing may be selected; if electrode assembly 10 is a cylindrical structure, a cylindrical casing may be selected.

The material of casing 20 may be various, for example, the material of casing 20 may be metal or plastic. Optionally, the material of the casing 20 may be copper, iron, aluminum, steel, aluminum alloy or the like.

In some embodiments, an end of the casing 20 is provided with an opening, and there is one end cover assembly 30 which covers the opening. In some other embodiments, both two ends of the casing 20 opposite to each other have openings, and there are two end cover assemblies 30 which cover the openings at two ends of the casing 20 respectively.

In some embodiments, the end cover assembly 30 includes an end cover 31, which is used to cover the opening of the casing 20. The shape of the end cover 31 may be matched with the shape of the casing 20 to fit the casing 20. Optionally, the end cover 31 may be made of the material with a certain hardness and strength (such as aluminum alloy), so that the end cover 31 is less prone to deformation when subjected to compression and collision, the battery cell 6 can have higher structural strength, and the safety performance can be improved.

The end cover 31 and the casing 20 enclose and form an accommodating cavity for accommodating the electrode assembly 10 and the electrolyte liquid.

In some embodiments, the end cover assembly 30 further includes a first electrode terminal 32 and a second electrode terminal 33 arranged on the end cover 31.

The polarity of the first electrode terminal 32 and the polarity of the second electrode terminal 33 are opposite. For example, if the first electrode terminal 32 is a positive electrode terminal, the second electrode terminal 33 will be a negative electrode terminal; if the first electrode terminal 32 is the negative electrode terminal, the second electrode terminal 33 will be the positive electrode terminal.

The first electrode terminal 32 and the second electrode terminal 33 are used to electrically connect the electrode assembly 10 to a circuit at the outside of the battery cell 6, so as to achieve the charging and discharging of the electrode assembly 10.

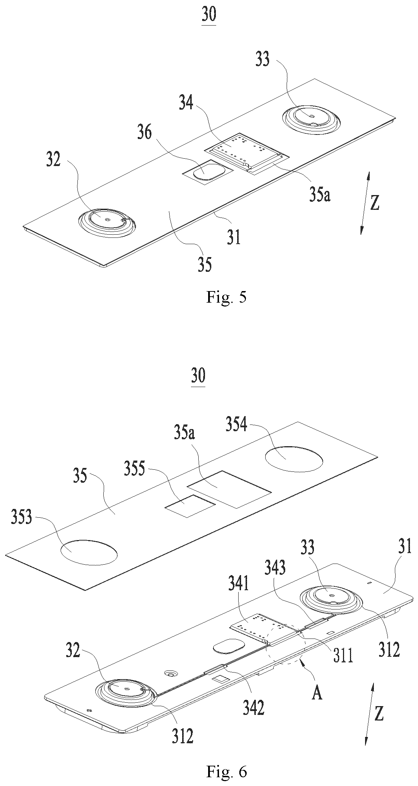

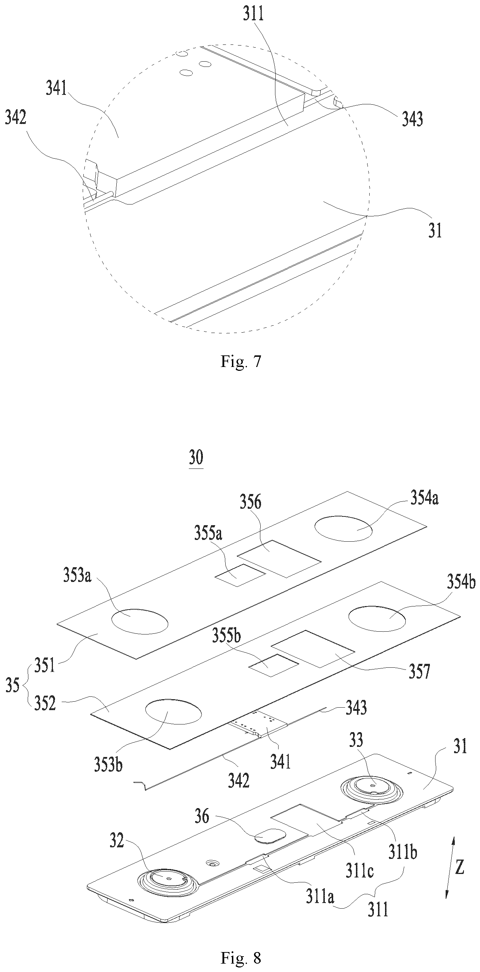

Fig. 5 shows a structural schematic view of an end cover assembly according to some embodiments of the present application; Fig. 6 shows an exploded structural schematic view of the end cover assembly shown in Fig. 5; Fig. 7 shows an enlarged schematic view at circle frame A of Fig. 6; Fig. 8 shows another exploded structural schematic of the end cover assembly shown in Fig. 5.

As shown in Fig. 5 to Fig. 8, the end cover assembly 30 in the embodiments of the present application includes an end cover 31, a detecting assembly 34 and an insulating member 35. The detecting assembly 34 is arranged on the end cover 31 and used to detect a state information of the battery cell 6. The insulating member 35 is attached to a surface of the end cover 31 away from the electrode assembly 10 of the battery cell 6. The insulating member 35 is provided with an avoiding structure 35a, which is used to avoid at least a portion of the detecting assembly 34.

The state information of the battery cell 6 is an information that characterizes a working state of the battery cell 6. Exemplarily, the state information of the battery cell 6 may include at least one of the temperature of the battery cell 6, the voltage of the battery cell 6, the deformation amount of the end cover 31, the internal pressure of the battery cell 6, the gas composition at the inside of the battery cell 6, the deformation amount of the electrode assembly 10, the dendritic crystal growing state at the inside of the electrode assembly 10, and the quantity of electricity at the inside of the battery cell 6.

"Attaching" may refer to bonding and connecting. Exemplarily, the insulating member 35 may be attached to the surface of the end cover 31 by bonding, coating or other means.

The avoiding structure 35a includes a hole, a slot, a notch or other structures that can provide a space for the detecting assembly 34 and reduce the interference between the insulating member 35 and the detecting assembly 34.

The avoiding structure 35a can avoid only a portion of the detecting assembly 34 or the entire detecting assembly 34.

The entire detecting assembly 34 may be located on the side of the end cover 31 away from the electrode assembly 10, or only a portion of the detecting assembly 34 may be located on the side of the end cover 31 away from the electrode assembly 10. Exemplarily, a portion of the detecting assembly 34 can pass through the end cover 31 and extend into the casing 20 of the battery cell 6 to detect the state information at the inside of the battery cell 6.

In the embodiments of the present application, the detecting assembly 34 can detect the state information of the battery cell 6 in real time, thereby regulating the battery cell 6 based on the state information of the battery cell 6, improving the cycling performance of battery cell 6, reducing the risk of safety, and prolonging the cycling life of the battery cell 6. By providing the avoiding structure 35a on the insulating member 35, the risk of interference between the detecting assembly 34 and the insulating member 35 can be reduced, and the connection strength between the insulating member 35 and the end cover 31 can be improved, and the detecting accuracy of the detecting assembly 34 can be improved.

In some embodiments, the state information includes at least one of the temperature of the battery cell 6, the voltage of the battery cell 6, the deformation amount of the end cover 31 and the internal pressure of the battery cell 6.

Exemplarily, the detecting assembly 34 can detect the temperature of the end cover 31 and use the detected temperature as the temperature of the battery cell 6. For example, the detecting assembly 34 may include a temperature sensor, which is attached against the end cover 31 to detect the temperature of the end cover 31; alternatively, the temperature sensor may be connected to the end cover 31 through a thermal-conducting adhesive to detect the temperature of the end cover 31.

Exemplarily, the detecting assembly 34 may include a voltage sensor, which may be electrically connected to the positive electrode terminal and negative electrode terminal of the battery cell 6 to detect the voltage of the battery cell 6.

Exemplarily, the detecting assembly 34 may include a displacement sensor, which may be against the end cover 31. The displacement sensor can measure the deformation of the end cover 31 during the charging and discharging process of the battery cell 6. Exemplarily, the detecting assembly 34 can calculate the change of the internal pressure of the battery cell 6 by detecting the deformation amount of the end cover 31.

In some embodiments, the avoiding structure 35a exposes at least a portion of the detecting assembly 34 to facilitate connection between the detecting assembly 34 and the component at the outside of the battery cell 6.

Exemplarily, the portion of the detecting assembly 34 exposed through the avoiding structure 35a can be connected to a control component of the battery through a cable.

In some embodiments, the end cover 31 is provided with a concave part 311, which is recessed from a surface of the end cover 31 away from the electrode assembly 10. At least a portion of the detecting assembly 34 is accommodated in the concave part 311.

By arranging the concave part 311 on the end cover 31, the size of a portion of the detecting assembly 34 protruding from the surface of the end cover 31 away from the electrode assembly 10 can be reduced, the space occupied by the end cover assembly 30 can be reduced, the energy density of the battery cell 6 can be improved, and the risk of interference between the detecting assembly 34 and the insulating member 35 can be reduced.

In some embodiments, the end cover assembly 30 further includes a first electrode terminal 32 and a second electrode terminal 33 with opposite polarities, the first electrode terminal 32 and the second electrode terminal 33 are mounted on the end cover 31, and the detecting assembly 34 is electrically connected to the first electrode terminal 32 and the second electrode terminal 33.

The detecting assembly 34 can detect an electric potential of the first electrode terminal 32 and an electric potential of the second electrode terminal 33, thereby obtaining a voltage of the battery cell 6 and detecting a working state of the battery cell 6.

In some embodiments, the end cover 31 is provided with two terminal holes 312, which penetrate through the end cover 31. The first electrode terminal 32 and the second electrode terminal 33 are mounted in the two terminal holes 312 respectively. By providing the terminal holes 312, the first electrode terminal 32 can be electrically connected to the electrode assembly 10, and the second electrode terminal 33 can be electrically connected to the electrode assembly 10.

In some embodiments, the detecting assembly 34 includes a chip 341, a first wire harness 342 and a second wire harness 343. The chip 341 is electrically connected to the first electrode terminal 32 through the first wire harness 342, and electrically connected to the second electrode terminal 33 through the second wire harness 343. The avoiding structure 35a exposes at least a portion of chip 341.

The first wire harness 342 can transmit an electric potential signal of the first electrode terminal 32 to the chip 341, and the second wire harness 343 can transmit an electric potential signal of the second electrode terminal 33 to the chip 341. The chip 341 can calculate the voltage of the battery cell 6 based on the electric potential signal of the first electrode terminal 32 and the electric potential signal of the second electrode terminal 33. The avoiding structure 35a exposes at least a portion of the chip 341, so as to facilitate the chip 341 providing the voltage signal feedback to the control component on the outside of the battery cell 6.

The control component can respond and adjust the working state of battery cell 6 based on the voltage signal detected by the chip 341, thereby improving the charging and discharging performance of the battery cell 6.

In some embodiments, the chip 341 includes the voltage sensor, which is electrically connected to the first wire harness 342 and the second wire harness 343. The voltage sensor is electrically connected to the first electrode terminal 32 through the first wire harness 342, and electrically connected to the second electrode terminal 33 through the second wire harness 343, so as to detect the electric potential difference between the first electrode terminal 32 and the second electrode terminal 33 and obtain the current working voltage of the battery cell 6.

In some embodiments, the chip 341 includes the temperature sensor, which is connected to the end cover 31. The temperature sensor can be directly connected to the end cover 31 or indirectly connected to the end cover 31 through a thermal-conducting structure (such as the thermal-conducting adhesive). The temperature sensor can detect the temperature of the end cover 31 to obtain the current working temperature of the battery cell 6, which is convenient for the control component to adjust the working state of battery cell 6.

In some embodiments, the chip 341 includes the displacement sensor, which is connected to the end cover 31. The displacement sensor can measure the deformation of the end cover 31 during the charging and discharging process of the battery cell 6. By detecting the deformation amount of the end cover 31, the change of the internal pressure of the battery cell 6 can also be calculated.

In some embodiments, the end cover 31 is provided with the concave part 311, which is recessed from the surface of the end cover 31 away from the electrode assembly 10. At least a portion of the first wire harness 342, at least a portion of the second wire harness 343 and at least a portion of the chip 341 are accommodated in the concave part 311.

The concave part 311 can provide an accommodating space for the first wire harness 342, the second wire harness 343 and the chip 341, thereby reducing the space occupied by the end cover assembly 30, improving the energy density of the battery cell 6, and reducing the risk of interference between the detecting assembly 34 and the insulating member 35.

In some embodiments, the concave part 311 includes a first accommodating region 311a, a second accommodating region 311b and a third accommodating region 311c. At least a portion of the chip 341 is accommodated in the third accommodating region 311c, the first accommodating region 311a and the second accommodating region 311b are located at two sides of the third accommodating region 311c, respectively. At least a portion of the first wire harness 342 is accommodated in the first accommodating region 311a, and at least a portion of the second wire harness 343 is accommodated in the second accommodating region 311b.

In some embodiments, the first accommodating region 311a and the second accommodating region 311b are strip-shaped.

In some embodiments, an end of the first accommodating region 311a away from the third accommodating region 311c is communicated with a terminal hole 312 provided with the first electrode terminal 32 to guide the first wire harness 342 to be connected to the first electrode terminal 32.

In some embodiments, an end of the second accommodating region 311b away from the third accommodating region 311c is communicated with a terminal hole 312 provided with the second electrode terminal 33 to guide the second wire harness 343 to be connected to the second electrode terminal 33.

In some embodiments, the insulating member 35 covers at least a portion of the first wire harness 342.

The insulating member 35 can cover the entire first wire harness 342, or cover only a portion of the first wire harness 342.

The insulating member 35 can protect the first wire harness 342 at the outside, so that the risk of the damage of the first wire harness 342 by an external component can be reduced, the leakage of electricity can be reduced, and the insulating performance can be improved.

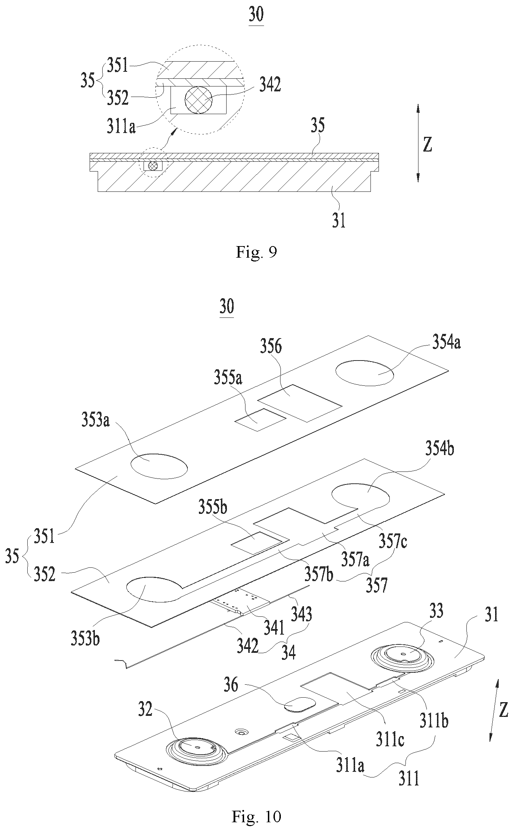

Fig. 9 shows a cross-sectional schematic view of an end cover assembly according to some embodiments of the present application.

Referring to Fig. 5 to Fig. 9 together, in some embodiments, the insulating member 35 abuts against the first wire harness 342 in a thickness direction Z of the end cover 31.

The insulating member 35 can limit the first wire harness 342 in the thickness direction Z, so as to reduce the movement of the first wire harness 342 when the battery cell 6 is subjected to the external impact, reduce the force on the first wire harness 342, and reduce the risk of breaking at a connecting place between the first wire harness 342 and the chip 341.

In some embodiments, the insulating member 35 abut against the second wire harness 343 in the thickness direction Z of the end cover 31.

In some embodiments, the insulating member 35 covers the first accommodating region 311a to limit the movement of the portion of the first wire harness 342 accommodated in the first accommodating region 311a.

In some embodiments, the insulating member 35 covers the second accommodating region 311b to limit the movement of the portion of the second wire harness 343 accommodated in the second accommodating region 311b.

In some embodiments, the insulating member 35 includes a base layer 351 and a bonding layer 352. The bonding layer 352 is located between the end cover 31 and the base layer 351 and is bonded to the end cover 31 and the base layer 351. By arranging the bonding layer 352, the assembling process between the insulating member 35 and the end cover 31 can be simplified.

In some embodiments, the bonding layer 352 is bonded to the first wire harness 342. The bonding layer 352 can fix the first wire harness 342 to reduce the movement of the first wire harness 342 in the concave part 311 when the battery cell 6 is subjected to the external impact.

In some embodiments, the insulating member 35 is sheet-shaped.

In some embodiments, the shape of the base layer 351 is the same as the shape of the bonding layer 352.

In some embodiments, the insulating member 35 further includes a first through hole 353, and the first electrode terminal 32 passes through the insulating member 35 through the first through hole 353.

The first through hole 353 penetrates through both of the base layer 351 and the bonding layer 352, and includes a first outer hole segment 353a located at the base layer 351 and a first inner hole segment 353b located at the bonding layer 352.

In some embodiments, the insulating member 35 further includes a second through hole 354, and the second electrode terminal 33 passes through the insulating member 35 through the second through hole 354.

The second through hole 354 penetrates through both of the base layer 351 and the bonding layer 352, and includes a second outer hole segment 354a located at the base layer 351 and a second inner hole segment 354b located at the bonding layer 352.

In some embodiments, the end cover assembly 30 further includes a pressure-releasing mechanism 36 arranged on the end cover 31. The insulating member 35 further includes a third through hole 355, which exposes the pressure-releasing mechanism 36. When the thermal runaway of battery cell 6 occurs, the internal material is released through the pressure-releasing mechanism 36. The third through hole 355 can avoid the pressure-releasing mechanism 36 to allow the internal material to be discharged smoothly.

The third through hole 355 penetrates through both of the base layer 351 and the bonding layer 352, and includes a third outer hole segment 355a located at the base layer 351 and a third inner hole segment 355b located at the bonding layer 352.

In some embodiments, the avoiding structure 35a includes a first hole 356 that penetrates through the base layer 351 and a second hole 357 that penetrates through the bonding layer 352.

In some embodiments, the first hole 356 and the second hole 357 correspond to each other in position and have the same shape. The chip 341 is exposed through the first hole 356 and the second hole 357.

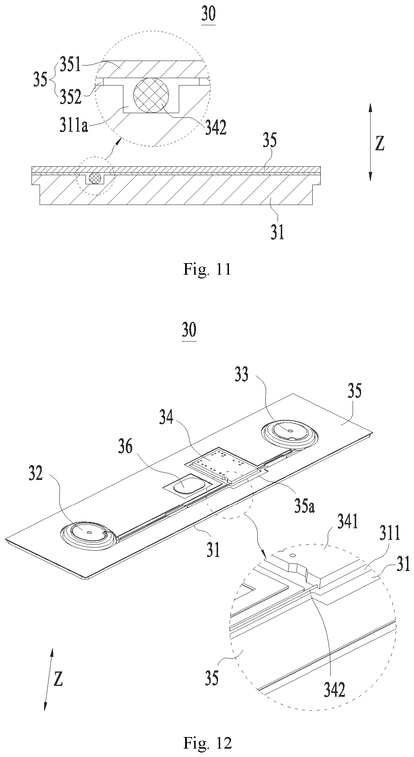

Fig. 10 shows an exploded structural schematic view of an end cover assembly according to some other embodiments of the present application; Fig. 11 shows a cross-sectional schematic view of an end cover assembly according to some other embodiments of the present application.

As shown in Fig. 10 and Fig. 11, in some embodiments, the avoiding structure 35a includes a first hole 356 that penetrates through the base layer 351 and a second hole 357 that penetrates through the bonding layer 352. The second hole 357 includes a first region 357a corresponding to the first hole 356 and a second region 357b covered by the base layer 351. A portion of the chip 341 is accommodated in the first region 357a and the first hole 356, and a portion of the first wire harness 342 is accommodated in the second region 357b.

The first hole 356 corresponds to the first region 357a in position, and the chip 341 can be exposed through the first region 357a and the first hole 356.

In the embodiments of the present application, the second region 357b that can accommodate the first wire harness 342 is formed by removing a portion of the bonding layer 352, so that the standard for the depth of the concave part 311 can be reduced. The base layer 351 can cover the first wire harness 342, so that the risk of the damage of the first wire harness 342 by the external component can be reduced, the leakage of electricity can be reduced, and the insulating performance can be improved.

In some embodiments, the shape of the first hole 356 is the same as that of the first region 357a.

In some embodiments, the shape of the second hole 357 is similar to that of the concave part 311.

In some embodiments, the base layer 351 abuts against the first wire harness 342 to limit the movement of the first wire harness 342 in the thickness direction Z.

In some embodiments, in the thickness direction Z of the end cover 31, the bonding layer 352 does not overlap with the concave part 311. According to the embodiments of the present application, the bonding layer 352 overflowing into the concave part 311 can be reduced, and the risk of the interference between the bonding layer 352 and the detecting assembly 34 at the inside of the concave part 311 can be reduced.

In some embodiments, the second hole 357 further includes a third region 357c, which is located on a side of the first region 357a away from the second region 357b and is covered by the base layer 351. A portion of the second wire harness 343 is accommodated in the third region 357c.

In some embodiments, the second region 357b is communicated with the first inner hole segment 353b. The third region 357c is communicated with the second inner hole segment 354b.

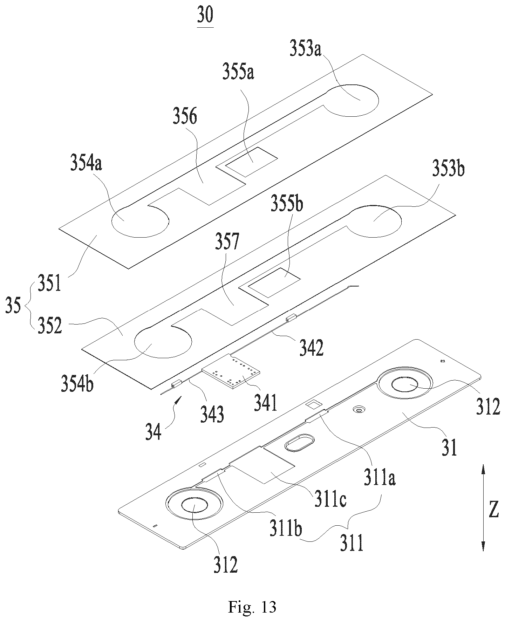

Fig. 12 shows a structural schematic view of an end cover assembly according to some other embodiments of the present application; Fig. 13 shows an exploded structural schematic view of the end cover assembly shown in Fig. 12.

As shown in Fig. 12 and Fig. 13, in some embodiments, the avoiding structure 35a exposes a portion of the first wire harness 342 corresponding to the concave part 311 and a portion of the second wire harness 343 corresponding to the concave part 311.

According to the embodiments of the present application, the standard for the depth of the concave part 311 can be reduced; even if the first wire harness 342 and second wire harness 343 protrude to the outside of the concave part 311, the avoiding structure 35a can still avoid the first wire harness 342 and the second wire harness 343, so that the risk of interference between the insulating member 35 and the first wire harness 342 and the risk of interference between the insulating member 35 and the second wire harness 343 can be reduced.

In some embodiments, the shape of the avoiding structure 35a is similar to that of the concave part 311.

In some embodiments, the insulating member 35 further includes a first through hole 353, and the first electrode terminal 32 passes through the insulating member 35 through the first through hole 353. The avoiding structure 35a is communicated with the first through hole 353.

In the present embodiment, the first wire harness 342 can enter into the first through hole 353 through the avoiding structure 35a, so as to facilitate connecting with the first electrode terminal 32 mounted in the first through hole 353 and reduce the risk of interference between the first wire harness 342 and the insulating member 35.

In some embodiments, the avoiding structure 35a includes a first hole 356 that passes through the base layer 351 and a second hole 357 that passes through the bonding layer 352. The first hole 356 and the second hole 357 correspond to each other in position and have the same shape. The chip 341, the first wire harness 342, and the second wire harness 343 are exposed through the first hole 356 and the second hole 357.

In some embodiments, the first hole 356 is communicated with the first outer hole segment 353a and the second outer hole segment 354a; the second hole 357 is communicated with the first inner hole segment 353b and the second inner hole segment 354b.

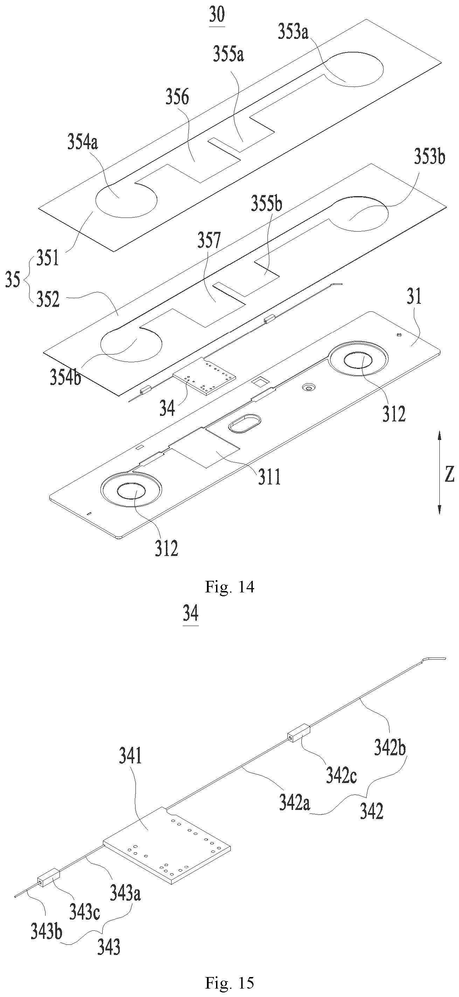

Fig. 14 shows an exploded structural schematic view of an end cover assembly according to some other embodiments of the present application; Fig. 15 shows a structural schematic view of the detecting assembly shown in Fig. 14.

As shown in Fig. 14 and Fig. 15, in some embodiments, the first hole 356 is communicated with all of the first outer hole segment 353a, the second outer hole segment 354a and the third outer hole segment 355a. The second hole 357 is communicated with all of the first inner hole segment 353b, the second inner hole segment 354b and the third inner hole segment 355b. According to the embodiments of present application, the forming process of the insulating member 35 can be simplified.

In some embodiments, the first wire harness 342 includes a first wire harness segment 342a, a second wire harness segment 342b and a connector 342c. The first wire harness segment 342a is connected to the chip 341, the second wire harness segment 342b is connected to the first electrode terminal 32, and the connector 342c is configured to connect the first wire harness segment 342a with the second wire harness segment 342b.

By arranging the connector 342c, the assembling process of detecting assembly 34 can be simplified, so that it is convenient to maintain and replace the detecting assembly 34.

Exemplarily, when the end cover assembly 30 is assembled, firstly, the first wire harness segment 342a is connected to the chip 341, and the second wire harness segment 342b can be connected to the first electrode terminal 32; then each of the chip 341 and the first electrode terminal 32 can be mounted on the end cover 31; finally, the connector 342c can be used to connect the first wire harness segment 342a with the second wire harness segment 342b. When the chip 341 malfunctions, the connector 342c is disconnected to disconnect the chip 341 with the first electrode terminal 32, so that it is convenient to replace or repair the chip 341.

In some embodiments, the portion of the concave part 311 for accommodating the connector 342c may be widened.

In some embodiments, the connector 342c includes a plug and a socket, one of which is connected to the first wire harness segment 342a and the other is connected to the second wire harness segment 342b.

In some embodiments, the second wire harness 343 includes a third wire harness segment 343a, a fourth wire harness segment 343b and a connector 343c. The third wire harness segment 343a is connected to the chip 341, the fourth wire harness segment 343b is connected to the second electrode terminal 33, and the connector 343c is used to connect the third wire harness segment 343a with the fourth wire harness segment 343b. The connector 343c of the second wire harness 343 can be the same as or different from the connector 343c of the first wire harness 342.

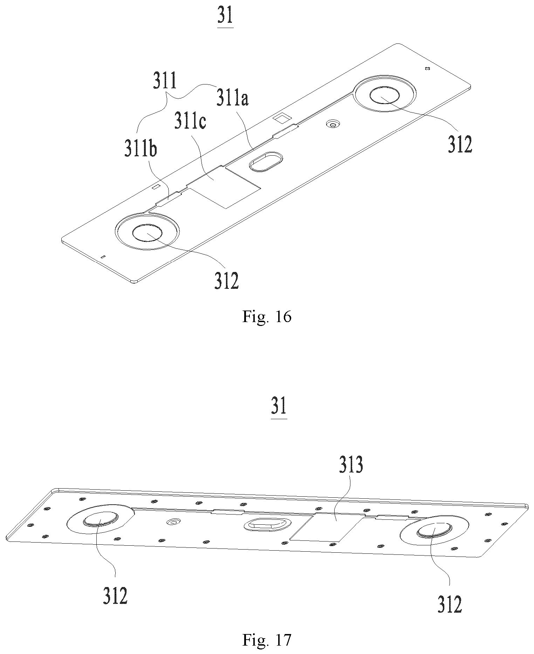

Fig. 16 shows a structural schematic view of an end cover of an end cover assembly according to some embodiments of the present application; Fig. 17 shows a structural schematic view of the end cover shown in Fig. 16 at another angle.

As shown in Fig. 16 and Fig. 17, in some embodiments, a convex part 313 is arranged on a side of the end cover 31 facing the electrode assembly 10, and the convex part 313 corresponds to the concave part 311 in position.

By arranging the convex part 313, the strength of the portion of the end cover 31 corresponding to the concave part 311 can increase, and the risk of rupture of the end cover 31 can be reduced. On the premise of meeting the strength requirement, by arranging the convex part 313, a depth of the concave part 311 can increase, so that more accommodating space can be provided for the detecting assembly 34, an overall size of the battery cell 6 can be reduced, and the energy density can be improved.

According to some embodiments of the present application, the present application also provides a battery cell including a casing, an electrode assembly and the end cover assembly according to any one of the above embodiments. The casing is provided with the opening. The electrode assembly is accommodated in the casing. The end cover of the end cover assembly is used to cover the opening.

According to some embodiments of the present application, the present application also provides a battery including a plurality of battery cells according to any one of the above embodiments.

According to some embodiments of the present application, the present application also provides an electricity-consuming apparatus, including the battery cell of any one of the above embodiments, which is used to supply the electric power to the electricity-consuming apparatus. The electricity-consuming apparatus may be a device or a system applying the battery cell according to any one of the above embodiments.

Referring to Fig. 4 to Fig. 8, some embodiments of the present application provide the end cover assembly 30 of the battery cell, including the end cover 31, the detecting assembly 34, the insulating member 35, the first electrode terminal 32 and the second electrode terminal 33. The first electrode terminal 32 and the second electrode terminal 33 are mounted on the end cover 31.

The detecting assembly 34 includes the chip 341, the first wire harness 342 and the second wire harness 343. The chip 341 is electrically connected to the first electrode terminal 32 through the first wire harness 342, and electrically connected to the second electrode terminal 33 through the second wire harness 343. The chip 341 can detect the voltage difference between the first electrode terminal 32 and the second electrode terminal 33 through the first wire harness 342 and the second wire harness 343, thereby obtaining the working voltage of the battery cell 6.

The end cover 31 is provided with the concave part 311, which is recessed from a surface of the end cover 31 away from the electrode assembly 10. At least a portion of the first wire harness 342, at least a portion of the second wire harness 343 and at least a portion of the chip 341 are accommodated in the concave part 311.

The insulating member 35 includes the base layer 351 and the bonding layer 352. The bonding layer 352 is located between the end cover 31 and the base layer 351 and is bonded to the end cover 31 and the base layer 351. The insulating member 35 includes the first hole 356 that penetrates through the base layer 351 and the second hole 357 that penetrates through the bonding layer 352. The chip 341 is exposed through the first hole 356 and the second hole 357. The base layer 351 covers a portion of the first wire harness 342 accommodated in the concave part 311 and a portion of the second wire harness 343 accommodated in the concave part 311.

It should be noted that, in the absence of conflict, the embodiments and the features in the embodiments of the present application can be combined with one another.

At last, it should be noted that the above embodiments are only used to illustrate the technical solutions of the present application, but not to limit the technical solutions; although the present application has been described in detail with reference to the embodiments as described above, those skilled in the art should understand that: it is still possible to modify the technical solutions recited in the embodiments as described above, or equivalently replace some of the technical features, but these modifications or replacements do not cause the essence of the corresponding technical solutions to deviate from the gist and scope of the technical solutions of the embodiments of the present application.

## Claims

1. An end cover assembly of a battery cell, comprising
an end cover;
a detecting assembly, arranged on the end cover and configured to detect a state information of the battery cell; and
an insulating member, attached to a surface of the end cover away from an electrode assembly of the battery cell, and provided with an avoiding structure which is configured to avoid at least a portion of the detecting assembly.

2. The end cover assembly according to claim 1, wherein the state information comprises at least one of a temperature of the battery cell, a voltage of the battery cell, a deformation amount of the end cover and an internal pressure of the battery cell.

3. The end cover assembly according to claim 1 or 2, wherein the avoiding structure exposes at least a portion of the detecting assembly.

4. The end cover assembly according to any one of claims 1-3, wherein the end cover is provided with a concave part, which is recessed from a surface of the end cover away from the electrode assembly;
at least a portion of the detecting assembly is accommodated in the concave part.

5. The end cover assembly according to claim 4, wherein a convex part is arranged on a side of the end cover facing the electrode assembly and corresponds to the concave part in position.

6. The end cover assembly according to any one of claims 1-5, further comprising a first electrode terminal and a second electrode terminal with opposite polarities, wherein the first electrode terminal and the second electrode terminal are mounted on the end cover, and the detecting assembly is electrically connected to the first electrode terminal and the second electrode terminal.

7. The end cover assembly according to claim 6, wherein the detecting assembly comprises a chip, a first wire harness and a second wire harness, and the chip is electrically connected to the first electrode terminal through the first wire harness and electrically connected to the second electrode terminal through the second wire harness;
the avoiding structure exposes at least a portion of the chip.

8. The end cover assembly according to claim 7, wherein the end cover is provided with a concave part, which is recessed from a surface of the end cover away from the electrode assembly;
at least a portion of the first wire harness, at least a portion of the second wire harness and at least a portion of the chip are accommodated in the concave part.

9. The end cover assembly according to claim 8, wherein the avoiding structure exposes a portion of the first wire harness corresponding to the concave part and a portion of the second wire harness corresponding to the concave part.

10. The end cover assembly according to claim 8, wherein the insulating member covers at least a portion of the first wire harness.

11. The end cover assembly according to claim 10, wherein the insulating member abuts against the first wire harness in a thickness direction of the end cover.

12. The end cover assembly according to claim 10 or 11, wherein the insulating member comprises a base layer and a bonding layer, and the bonding layer is located between the end cover and the base layer and is bonded to the end cover and the base layer.

13. The end cover assembly according to claim 12, wherein the avoiding structure comprises a first hole that penetrates through the base layer and a second hole that penetrates through the bonding layer, and the second hole comprises a first region corresponding to the first hole and a second region covered by the base layer;
a portion of the chip is accommodated in the first region and the first hole, and a portion of the first wire harness is accommodated in the second region.

14. The end cover assembly according to claim 12 or 13, wherein the bonding layer does not overlap with the concave part in a thickness direction of the end cover.

15. The end cover assembly according to any one of claims 7-14, wherein the first wire harness comprises a first wire harness segment, a second wire harness segment and a connector, the first wire harness segment is connected to the chip, the second wire harness segment is connected to the first electrode terminal, and the connector is configured to connect the first wire harness segment with the second wire harness segment.

16. The end cover assembly according to any one of claims 7-15, wherein the chip comprises a voltage sensor, a temperature sensor and a displacement sensor, the voltage sensor is electrically connected to the first wire harness and second wire harness, and both of the temperature sensor and the displacement sensor are connected to the end cover.

17. The end cover assembly according to any one of claims 6-16, wherein the insulating member further comprises a first through hole, and the first electrode terminal passes through the insulating member through the first through hole;
the avoiding structure is communicated with the first through hole.

18. A battery cell comprising:
a casing, provided with an opening;
an electrode assembly, accommodated in the casing; and
the end cover assembly according to any one of claims 1-17, the end cover being configured to cover the opening.

19. A battery comprising the battery cell according to any one of claims 1-18.

20. An electricity-consuming apparatus, comprising the battery according to claim 19, which is configured to supply electric power.
